# EUROPEAN PATENT APPLICATION

(11) **EP 1 464 992 A1**
(43) Date of publication of application: **06.10.2004**
(21) Application number: 02786076.6
(22) Date of filing: 10.12.2002
(51) Int. Cl.: G02B 1/02, C03B 29/12

(54) **FLUORIDE CRYSTAL MATERIAL FOR OPTICAL DEVICE USED FOR PHOTOLITHOGRAPHIC APPARATUS AND ITS MANUFACTURING METHOD**

(30) Priority: 10.12.2001 JP 2001375775
(71) Applicant: Nikon Corporation, Tokyo 100-8831 (JP)
(72) Inventor: SAKUMA, Shigeru c/o Nikon Corporation, Tokyo 100-8331 (JP)
(74) Representative: Wiebusch, Manfred
(86) International application number: PCT/JP2002/012928
(87) International publication number: WO 2003/054590

(57) **Abstract**

An optical device to be used for a photolithography apparatus comprises a lens which is formed of a fluoride crystal material, a holder which holds the lens, and a pressing member which is attached to the holder and which presses the lens in order to generate a stress in the lens. The stress can be generated in the lens by pressing the lens in a specified orientation with the pressing member to reduce the birefringence of the lens. When the lens is composed of a calcium fluoride crystal, then the maximum value of the birefringence amount with respect to a light beam having a wavelength of about 157 nm can be made not more than 2.0 nm/cm within an effective aperture (light-transmitting area) of the lens, or the maximum value of the birefringence amount with respect to a light beam having a wavelength of about 193 nm can be made not more than 1.0 nm/cm within the effective aperture of the lens.

## Description

### TECHNICAL FIELD

The present invention relates to a fluoride crystal material for an optical element to be used for a photolithography apparatus, and a method for producing the same. In particular, the present invention relates to a fluoride crystal material for an optical element to be used for a photolithography apparatus which uses a light source of a light beam having a wavelength of not more than 200 nm, for example, a light beam having a wavelength of 193 nm or 157 nm, and a method for producing the same. The present invention also relates to an optical element, an optical device, and a photolithography apparatus based on the use of the fluoride crystal material.

### BACKGROUND ART

In recent years, VLSI undergoes the advance of the high integration and the high function, in which it is required to adopt a micromachining technique on the wafer. As for the machining method, a method based on the photolithography is generally adopted. At present, the exposure wavelength is gradually shortened as well. Projection exposure apparatuses (steppers and scanners) which use light sources of the KrF excimer laser light beam (wavelength: 248 nm) as well as projection exposure apparatuses which use light sources of the ArF excimer laser light beam (wavelength: 193 nm) have been also commercially available in the market.

A projection lens of the projection exposure apparatus, which is the pivotal point of the photolithography technique, is required to have a high degree of image formation performance (including those concerning the resolution and the depth of focus). The resolution and the depth of focus are determined by the wavelength λ of the light beam to be used for the exposure and the numerical aperture NA of the lens, and they are represented by (resolution) = k₁·λ/NA, (depth of focus) = k₂·λ/(1-√(1-NA²)). In the expressions, k₁ and k₂ are proportional constants. When the exposure wavelength λ is identical, the angle of diffracted light is increased as the pattern is finer. Therefore, it is impossible to incorporate or pick up the diffracted light unless NA of the lens is large. Further, the shorter the exposure wavelength λ is, the smaller the angle of diffracted light obtained for an identical pattern is. Therefore, in such a case, it is enough that NA of the lens is small.

According to the expressions described above, it is appropriate that NA of the lens is increased (aperture of the lens is increased) or the exposure wavelength λ is shortened in order to improve the resolution. In particular, according to the expressions described above, it is appreciated that the decrease in λ is more advantageous than the increase in NA in order to enhance the resolution while maintaining a deep depth of focus. Therefore, it has been tried to shorten the wavelength of the light source in order to realize a higher degree of micromachining by means of the photolithography. In relation to the realization of the short wavelength of the light beam, the exposure wavelength λ is shortened from the wavelength of 248 nm of the KrF excimer laser light beam to the wavelength of 193 nm of the ArF excimer laser light beam. Further, it is postulated that the exposure wavelength λ may be progressively shortened to the wavelength of 157 nm of the F₂ laser beam.

On the other hand, in relation to the realization of the large aperture of the lens, the numerical aperture NA of the lens has already exceeded 0.6 in the case of the projection lens of the projection exposure apparatus which uses the KrF excimer laser light beam as the light source, and NA has been larger than the above in the case of the ArF excimer laser. It is also postulated that NA may be not less than 0.7 in the case of the projection lens which uses the F₂ laser as the light source.

The optical material, which is used for the photolithography projection lens for the light source wavelength of not more than 250, is available extremely scarcely. Those principally used are those of two types of calcium fluoride crystal and quartz glass. It is postulated to be already difficult to use quartz glass for the photolithography projection lens for the F₂ laser beam. In such a case, it is considered that calcium fluoride crystal may be promising.

The single crystal of calcium fluoride is generally produced by the Bridgman method (also referred to as "Stockbarger method" or "crucible downward movement method"). In the case of the single crystal of calcium fluoride to be used in the ultraviolet region or the vacuum ultraviolet region, a high purity raw material, which is manufactured by the chemical synthesis, is generally used without using natural fluorite as the raw material. A powdery raw material can be also used as it is. However, in this case, the volume is conspicuously decreased when the powder is melted. Therefore, in general, a semi-molten material or a pulverized material obtained therefrom is used. Alternatively, a block, which is obtained by means of the crystal growth, can be reused as a raw material for the calcium fluoride single crystal as well.

An explanation will now be made about a method for producing calcium fluoride in accordance with the Bridgman method. At first, a crucible, which is filled with a raw material of calcium fluoride, is placed in a growth apparatus. The interior of the growth apparatus is evacuated to retain a vacuum atmosphere of 10⁻³ to 10⁻⁴ Pa. Subsequently, the temperature in the growth apparatus is raised to a temperature of not less than the melting point of calcium fluoride to melt the raw material contained in the crucible. During this process, in order to suppress the time-dependent change of the temperature in the growth apparatus to the minimum, the control based on the constant electric power output or the highly accurate PID control is performed.

At the crystal growth stage, the crucible is moved downwardly in the growth apparatus at a speed of about 0.1 to 5 mm/hour, and thus the crystallization is gradually caused from the bottom of the crucible. When the crystallization is effected up to the uppermost portion of the molten liquid, the crystal growth is completed. Gradual cooling is simply performed while avoiding any sudden cooling so that the grown crystal (ingot) is not broken. When the temperature in the growth apparatus is lowered to a temperature in the vicinity of room temperature, the apparatus is open to the atmospheric air to take out the ingot therefrom.

High homogeneity is required for the single crystal of calcium fluoride to be used, for example, for the projection lens of the projection exposure apparatus. Therefore, the ingot is subjected to the simple annealing (heat treatment) as it is. The ingot is cut and processed to have a size appropriate for the lens material, and then the annealing is performed again. After completing the annealing, various characteristics are measured to guarantee the quality, and the lens material is subjected to the selection. The lens material, which has come up to the standard of the guarantee of quality, is subjected to the spherical surface polishing or the non-spherical surface polishing to obtain a surface shape required for the optical lens, and the coating treatment is applied thereto. The optical lens, which has been finished as described above, is held one by one at its circumference by a holding tool made of metal or resin. A plurality of lenses are subjected to the adjustment, and they are incorporated into a container called "body tube". Thus, the projection lens is completed.

The birefringence or double refraction, which is intrinsic or inherent in the crystal, exists in the fluoride crystal (for example, calcium fluoride, barium fluoride, and strontium fluoride) belonging to the tesseral system. For example, in the case of the calcium fluoride crystal, the existing birefringence includes 3.4 nm/cm with respect to a light beam having a wavelength of 193 nm and 11.2 nm/cm with respect to a light beam having a wavelength of 157 nm respectively in the crystal plane orientation in which the maximum intrinsic birefringence appears (J. H. Burnett et al., Phys. Rev. B64, 241102 (2001)). The amount of the intrinsic birefringence depends on the direction of advance of the light beam and the direction of polarization of the light beam transmitted through the crystal. That is, there are the direction of polarization (phase advance axis) in which the refractive index is minimum and the direction of polarization (phase lag axis) in which the refractive index is maximum depending on the direction of the transmitted light beam. The phase advance axis and the phase lag axis are perpendicular to one another.

When a projection lens for the photolithography is manufactured by using material of a fluoride crystal having any intrinsic birefringence (birefringence inherent in the fluoride crystal), then the fluoride crystal material is processed to have a disk-shaped configuration, and the surface is subsequently subjected to the spherical surface polishing or the non-spherical surface polishing depending on the optical design. When a light beam is radiated onto the processed projection lens, the light beam passes through the optical axis (central axis of the lens) at the center of the lens. However, the light beam comes into the other portions of the lens at angles of incidence having finite magnitudes with respect to the optical axis, and the light beam is affected by the birefringence. For example, the intrinsic birefringence scarcely exists with respect to the light beams which are allowed to perpendicularly come into the {111} plane and the {100} plane of the fluoride crystal. However, the intrinsic birefringence exists with respect to the light beams deviated from the perpendicular direction, i.e., the incoming light beams having angles in relation to the vertical axes of the {111} plane and the {100} plane.

Therefore, when a light beam, which has a wavelength of not more than 200 nm, for example, which has a wavelength of 193 nm or 157 nm, is allowed to come into the projection lens for the photolithography manufactured with the fluoride crystal, the following problem has arisen. That is, the Strehl intensity is lowered due to the intrinsic birefringence involved in the fluoride crystal, and the image formation performance is deteriorated. The Strehl intensity is also referred to as "point image intensity distribution", and it represents the ratio between the height of the highest point of the diffracted image of the lens having the aberration and the height of the peak of the aplanatic lens having no aberration. The Strehl intensity is 1.0 in the case of the aplanatic lens. The Strehl intensity has a positive value smaller than 1 as the aberration is increased.

The present inventors have disclosed, in Japanese Patent Application Laid-open No. 11-240798, a method for producing a fluorite single crystal having sufficiently small birefringence to be used for an optical system for photolithography. In this method, the fluorite single crystal, which is produced by means of the Bridgman method, is subjected to an annealing treatment in accordance with a specified temperature schedule. However, in the case of this document, the crystal is not heated in accordance with such a method that a specified heat distribution or thermal distribution arises.

### DISCLOSURE OF THE INVENTION

The present invention has been made in order to solve the problems involved in the conventional technique as described above. A first object of the present invention is to provide material of a fluoride crystal in which the intrinsic birefringence of fluoride crystal is reduced, and a method for producing the same. A second object of the present invention is to provide an optical element which has satisfactory image formation characteristics with respect to light beams in the short wavelength region such as the vacuum ultraviolet region, as well as an optical device and a photolithography apparatus based on the use of the same.

According to a first aspect of the present invention, there is provided a fluoride crystal material for an optical element to be used for a photolithography apparatus, wherein a birefringence amount with respect to a light source having a wavelength of about 157 nm has a maximum value of not more than 2.0 nm/cm.

According to a second aspect of the present invention, there is provided a fluoride crystal material for an optical element to be used for a photolithography apparatus, wherein a birefringence amount with respect to a light source having a wavelength of about 193 nm has a maximum value of not more than 1.0 nm/cm.

In the fluoride crystal material for the optical element according to the present invention, the birefringence amount is suppressed to be extremely low with respect to the light beam having the short wavelength, i.e., the wavelength of about 157 nm or about 193 nm as well. Therefore, it is possible to maintain satisfactory image formation characteristics even when the short wavelength light source is used. As appreciated from embodiments described later on, it has been achieved that the average value of the birefringence amount is not more than 1.7 nm/cm with respect to the light beam having the wavelength of about 157 nm, and the average value is not more than 0.8 nm/cm with respect to the light beam having the wavelength of about 193 nm. The fluoride crystal material as described above is obtained such that the phase advance axis (as well as the phase lag axis) of the refractive index of the fluoride crystal cut out in a disk shape from an ingot of the fluoride crystal is determined by measurement or calculation, and the internal stress is generated in the fluoride crystal material on the basis of the obtained characteristic so that the intrinsic birefringence of the crystal is reduced.

It is preferable that the fluoride crystal material for the optical element of the present invention is a calcium fluoride crystal. In this case, a light-incoming plane (incident plane) of the calcium fluoride crystal may be a {111} plane, a {110} plane, or a {100} plane.

In the fluoride crystal material for the optical element according to the present invention, the internal stress is generated in the fluoride crystal material so that the birefringence amount, which is inherent in the fluoride crystal material, is reduced. The internal stress may be generated by externally pressing the fluoride crystal material, or by heat-treating the fluoride crystal material. Further, the internal stress may be generated by both of the heat treatment and the external pressing treatment applied to the fluoride crystal material.

According to the present invention, there are also provided an optical element which is formed of the fluoride crystal material of the present invention, and a photolithography apparatus comprising the optical element. The optical element and the photolithography apparatus are most appropriate for light sources having short wavelengths such as the F₂ laser to be used to obtain the high resolution.

According to a third aspect of the present invention, there is provided an optical device to be used for a photolithography apparatus, the optical device comprising:
a lens which is formed of a fluoride crystal material;
a holder which holds the lens; and
a pressing member which is attached to the holder and which presses the lens in order to generate a stress in the lens.

The optical device of the present invention is provided with the pressing member which presses the lens in order to generate the stress in the lens. Therefore, the birefringence of the lens can be reduced by pressing the lens in a specified orientation of the lens to generate the stress in the lens. For example, when the lens is composed of a calcium fluoride crystal, then the maximum value of the birefringence amount with respect to the light beam having the wavelength of about 157 nm can be made to be not more than 2.0 nm/cm within the effective aperture (light-transmitting area) of the lens, or the maximum value of the birefringence amount with respect to the light beam having the wavelength of about 193 nm can be made to be not more than 1.0 nm/cm within the effective aperture of the lens. In the optical device of the present invention, the pressing member is provided on the holder. Therefore, it is possible to maintain the state in which the pressing force is applied to the lens as long as the lens is retained by the holder.

The pressing member may include a plurality of pressing sections (internal stress-generating members), and the respective pressing sections may press the lens at different positions on an outer circumference of the lens. Considering the plane orientation in which the birefringence of the fluoride crystal material appears, it is desirable that the pressing sections are provided on the holder so that the respective pressing sections press the lens at rotationally symmetric positions on the outer circumference of the lens, for example, at positions of two-fold symmetry, three-fold symmetry, and four-fold symmetry. More specifically, the pressing sections can be provided on the holder corresponding to positions of intervals of 30° (support at 12 points), intervals of 60° (support at 6 points), intervals of 120° (support at 3 points), or intervals of 180° (support at 2 points) in the circumferential direction with respect to the central axis of the lens. Holding members, which hold the lens, may be provided on the holder separately from the pressing members. Alternatively, the lens may be held by the pressing members. When the holding members are provided on the holder, the holding members may be constructed to grip the outer circumference of the lens.

The optical device may further comprise a fixing member, for example, a holding screw which fixes the pressing sections on the holder in a state in which the respective pressing sections press the lens. When the holder is previously designed depending on the way of use of the installation of the lens, the holder can be installed as it is. For example, the holder may constitute a part of a body tube of a projection optical system to be used for photolithography. By doing so, it is easy to assemble the projection optical system and adjust various characteristics of the lens.

According to a fourth aspect of the present invention, there is provided a method for producing a fluoride crystal material for an optical element to be used for a photolithography apparatus, the method comprising a step of growing a fluoride crystal and a heat treatment step of heating the grown fluoride crystal to a raised temperature and retaining the temperature for a certain period of time followed by cooling the grown fluoride crystal, wherein:
the fluoride crystal is heated in the heat treatment step so that a nonuniform heat distribution is generated in the fluoride crystal.

In the method for producing the fluoride crystal material according to the present invention, the fluoride crystal is heated so that the nonuniform heat distribution is generated in the fluoride crystal. Therefore, it is possible to generate an internal stress (thermal stress) to counteract an intrinsic birefringence amount of the fluoride crystal when the temperature is raised or when the temperature is lowered. As for the apparatus to be used for the heat treatment, for example, it is possible to use a heat treatment furnace which can bring about the temperature distribution of three-fold symmetry or four-fold symmetry in the circumferential direction with respect to the central axis of the fluoride crystal material. The temperature distribution as described above can be realized by arranging heaters at desired symmetric positions in the heat treatment furnace, or by arranging, for example, heat-insulating materials, reflecting plates, heat-releasing plates at desired symmetric positions.

For example, in the case of a fluoride crystal material which is cut out to have a disk-shaped configuration so that the {111} plane appears on the upper and lower surfaces of a lens, the peaks of the intrinsic birefringence amount exist at intervals of 120° in the circumferential direction with respect to the vertical axis of the disk-shaped fluoride crystal material. That is, the distribution of the birefringence amount has a shape of distribution of three-fold symmetry in the circumferential direction with respect to the vertical axis of the disk-shaped fluoride crystal material. The birefringence scarcely appears when the light beam comes into the material in the same direction as the vertical axis. However, when the fluoride crystal material is used as the lens, the intrinsic birefringences appear in directions other than the direction of the {111} plane with respect to the light beams coming obliquely with respect to the vertical axis. Accordingly, the heat treatment furnace is prepared, which can give the temperature distribution of three-fold symmetry in the circumferential direction with respect to the central axis of the fluoride crystal material to the fluoride crystal material cut out to have the disk-shaped configuration so that the {111} plane appears on the upper and lower surfaces. When the fluoride crystal material is arranged at the center of the heat treatment furnace to perform the heat treatment, the internal stress, which is nonuniform (three-fold symmetry) in the circumferential direction with respect to the central axis, can be generated in the fluoride crystal material cut out to have the disk-shaped configuration so that the {111} plane appears on the upper and lower surfaces. Accordingly, it is possible to reduce the birefringence amount of the entire fluoride crystal by lowering the intrinsic birefringence of the fluoride crystal material with respect to the obliquely incoming light beam.

According to a fifth aspect of the present invention, there is provided a method for producing a fluoride crystal material for an optical element to be used for a photolithography apparatus, the method comprising a step of growing a fluoride crystal and a heat treatment step of heating the grown fluoride crystal to a raised temperature and retaining the temperature for a certain period of time followed by cooling the grown fluoride crystal, wherein:
the method further comprises a step of partially pressing the fluoride crystal so that an internal stress is generated in the fluoride crystal to which the heat treatment step is applied.

As in the method according to the fifth aspect of the present invention, the following procedure may be also available. That is, the heat treatment is performed in the state in which the pressing force is applied to the outer circumference of the fluoride crystal material, and the external stress is removed after the completion of the heat treatment so that the internal stress is generated in the fluoride crystal material thereby. As for the pressing force to be applied to the outer circumference, the pressing force may be applied nonuniformly in the circumferential direction with respect to the central axis of the fluoride crystal material, for example, in three-fold symmetry or four-fold symmetry in the circumferential direction with respect to the central axis. In this method, for example, a pressing force may be partially applied to the fluoride crystal by using a holder provided with a pressing member to hold the fluoride crystal, and the holder, which holds the fluoride crystal, may be subjected to the heat treatment step.

### BRIEF DESCRIPTION OF THE DRAWINGS

Fig. 1 shows an optical element which holds a calcium fluoride crystal described in a first embodiment, wherein Fig. 1(a) shows a plan view, and Fig. 1(b) shows a sectional view taken in a direction along a broken line A1-A1 shown in Fig. 1(a).
Fig. 2 shows a method for holding the calcium fluoride crystal adopted when the birefringence of the calcium fluoride crystal described in the first embodiment is measured, wherein Fig. 2(a) shows a plan view, and Fig. 2(b) shows a sectional view taken in a direction along a broken line A2-A2 shown in Fig. 2(a).
Fig. 3 shows a method for measuring the birefringence with respect to an obliquely incoming light beam coming into the calcium fluoride crystal described in the first embodiment.
Fig. 4 shows an optical element which holds a calcium fluoride crystal described in a second embodiment, wherein Fig. 4(a) shows a plan view, and Fig. 4(b) shows a sectional view taken in directions along broken lines A3-A3 shown in Fig. 4(a).
Fig. 5 shows a method for holding the calcium fluoride crystal adopted when the birefringence of the calcium fluoride crystal described in the second embodiment is measured, wherein Fig. 5(a) shows a plan view, and Fig. 5(b) shows a sectional view taken in a direction along a broken line A4-A4 shown in Fig. 5(a).
Fig. 6 shows an optical element which holds a calcium fluoride crystal described in a third embodiment, wherein Fig. 6(a) shows a plan view, and Fig. 6(b) shows a sectional view taken in directions along broken lines A5-A5 shown in Fig. 6(a).
Fig. 7 shows a method for holding the calcium fluoride crystal adopted when the birefringence of the calcium fluoride crystal described in the third embodiment is measured, wherein Fig. 7(a) shows a plan view, and Fig. 7(b) shows a sectional view taken in a direction along a broken line A6-A6 shown in Fig. 7(a).
Fig. 8 shows a structural sectional view illustrating a heat treatment furnace to be used to anneal a calcium fluoride crystal in which upper and lower surfaces of a flat plate are the {111} plane as described in a fourth embodiment.
Fig. 9 shows a method for holding a calcium fluoride crystal adopted when a heat treatment is performed as described in a fifth embodiment, wherein Fig. 9(a) shows a plan view, and Fig. 9(b) shows a sectional view taken in a direction along a broken line A7-A7 shown in Fig. 9(a).
Fig. 10 conceptually shows an entire structure of a photolithography apparatus.

### BEST MODE FOR CARRYING OUT THE INVENTION

### First Embodiment

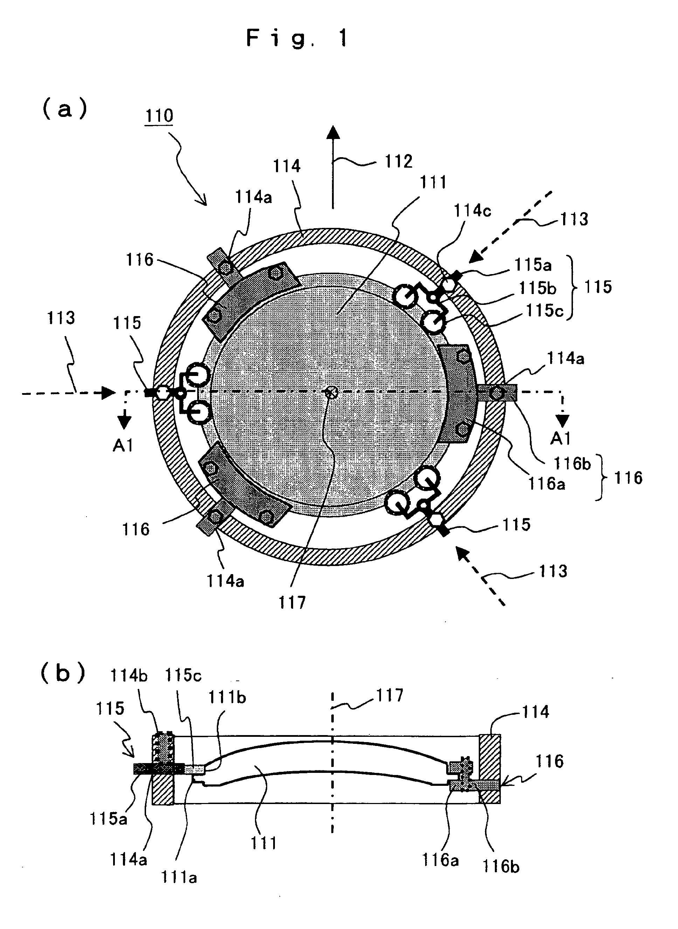

Figs. 1(a) and 1(b) show an optical element (optical device) which is used for the lithography and which is manufactured in a first embodiment. As shown in Figs. 1(a) and 1(b), the optical element 110 manufactured in this embodiment comprises a lens 111, a cylindrical holder 114, three holding members 116, and three internal stress-generating members (pressing members) 115.

The lens 111 is a circular plate-shaped concavo-convex lens formed of calcium fluoride crystal. The optical axis (central axis) 117 of the lens 111 is approximately coincident with the [111] axis of the calcium fluoride crystal. The phrase "approximately coincident with" herein means the fact that the optical axis is coincident with the designated axis of the crystal at an accuracy within ±3°. As shown in Fig. 1(b), the lens 111 has an outer circumferential side wall 111b which has a projection 111a formed in the circumferential direction.

The lens 111 is retained in the holder 114 by the holding members 116 which are formed on the cylindrical holder 114. As shown in Fig. 1(a), the three holding members 116 are provided on the holder 114. The holding members 116 are provided at intervals of about 120° in the circumferential direction of the holder 114. As shown in Fig. 1(b), each of the holding members 116 has an arm 116b which extends from an inner portion of the inner circumferential wall of the holder 114 toward the center of the holder, and a gripping section (recess) 116a which is provided at the tip of the arm 116b. The gripping section 116a is structured to interpose upper and lower surfaces of the projection 111a which is formed on the side wall of the outer circumference of the lens 111. The projection 111a of the outer circumference of the lens 111 is interposed by the gripping sections 116a of the holding members 116, and thus the lens 111 is held coaxially with the central axis of the holder 114. However, as shown in Fig. 1(a), the holding members 116 and the internal stress-generating members 115 are provided at such positions that they are not overlapped with each other in the circumferential direction.

The holder 114 is provided with the three internal stress-generating members (pressing sections) 115 for generating the internal stress in the lens 111. Each of the members 115 includes a rod 115a which is movably inserted into a through-hole 114a penetrating through the wall surface of the holder 114, an arm 115b which is formed by branching at the end of the rod 115a disposed on the side of the lens, and circular plate-shaped elastic members 115c which are attached to the tips of the arm 115b. The rod 115a is fixed to the holder 114 at a certain position by pressing the rod 115a by a screw 114c which is inserted into a screw hole 114b formed in the holder 114. The internal stress-generating members 115 are provided at positions of 30°, 150°, and 270° in the circumferential direction of the holder 114 from the [-110] axis 112 which is perpendicular to the central axis 117 ([111] axis) of the lens. The pressing force 113 is applied to the end of the rod 115a of the internal stress-generating member 115 disposed outside the holder in the direction toward the central axis 117 of the lens. Accordingly, as shown in Fig. 1(b), the elastic members 115c of the internal stress-generating member 115 press the outer circumferential wall surface 111b of the lens 111, and the pressing force 113 is applied from the outside of the holder 114 in the radial direction toward the central axis 117 of the lens 111. When the internal stress is generated in the lens 111, the pressures, which are applied by the respective internal stress-generating members 115, are adjusted respectively so as to reduce the intrinsic birefringence of the calcium fluoride crystal as the material for the lens 111.

A method for manufacturing the optical element 110 for lithography will be explained below. At first, the calcium fluoride crystal to be used for the lens 111 was prepared by effecting the growth by the Bridgman method and removing any thermal strain by performing a heat treatment step. In this embodiment, the columnar calcium fluoride crystal having a diameter of 250 mm was prepared. Subsequently, a disk-shaped material was cut out from the ingot of the prepared calcium fluoride crystal so that the [111] axis of the calcium fluoride crystal was approximately coincident with the central axis of the lens. The direction of the [-110] axis perpendicular to the [111] axis was found in the cut out disk-shaped material by means of the X-ray diffraction.

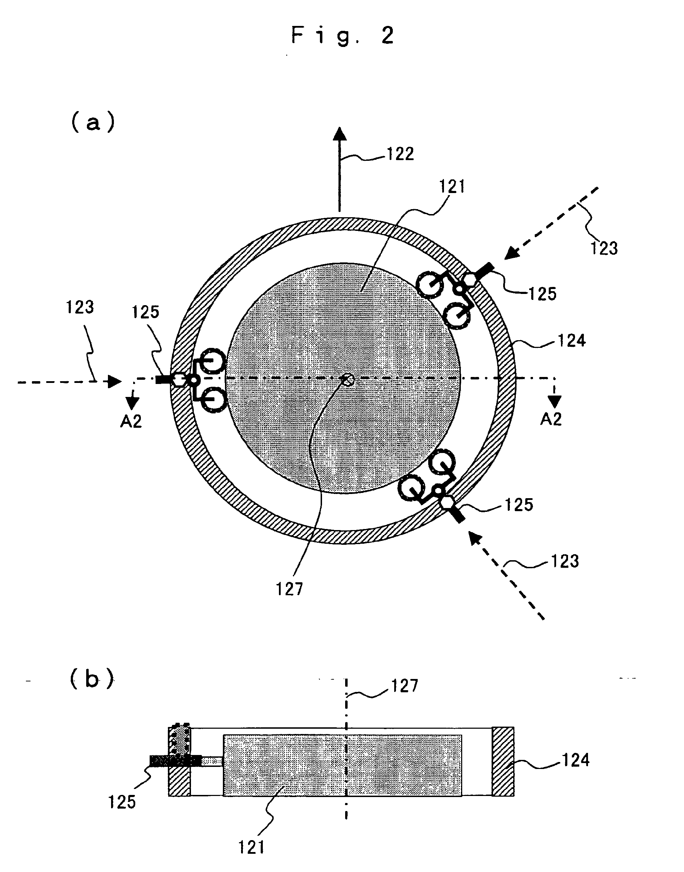

Subsequently, the obtained disk-shaped calcium fluoride crystal material was installed to a holder for measuring the birefringence to measure the birefringence amount of the calcium fluoride crystal material. Figs. 2(a) and 2(b) show a situation in which the calcium fluoride crystal material is installed to the holder 124 for measuring the birefringence. The holder 124 has the same structure as that of the holder 114 shown in Fig. 1 except that the holding members are not provided. As shown in Fig. 2(a), the calcium fluoride crystal material 121 was arranged coaxially with the central axis of the holder 124. The calcium fluoride crystal material 121 was held by the internal stress-generating members 125 while the pressing forces 123 of about 50 N/cm² were applied perpendicularly to the central axis 127 toward the central axis 127 from the outside of the calcium fluoride crystal material 121 in the radial direction respectively in the three directions by using the internal stress-generating members 125 provided at the positions of 30°, 150°, and 270° in the circumferential direction of the holder 124 from the [-110] axis 122 of the calcium fluoride crystal material 121.

Light beams having wavelengths of 193 nm and 157 nm were radiated in parallel to the central axis 127 respectively onto the calcium fluoride crystal material 121 held and pressurized by the three internal stress-generating members 125 to measure the birefringence amounts of the calcium fluoride crystal material 121. In this embodiment, a D₂ lamp was used for the light source, and the birefringence amount was measured by using a birefringence-measuring apparatus. Obtained results are shown in Table 1A below. The measurement was performed while moving the light irradiation position at intervals of 5 mm in the radial direction and at intervals of 30° in the circumferential direction in an in-plane area ranging from the center to the outermost circumference of the calcium fluoride crystal material 121. Table 1A shows maximum values and average values of measured values. For the purpose of comparison, birefringence amounts, which were obtained when no pressing force was applied to the calcium fluoride crystal material 121, are also shown.

**Table 1A**

| Pressing force [N/cm²] | 193 nm | | 157 nm | |
|---|---|---|---|---|
| | Average [nm/cm] | Maximum [nm/cm] | Average [nm/cm] | Maximum [nm/cm] |
| 0 | 0.8 | 1.0 | 1.4 | 2.6 |
| 50 | 0.3 | 0.7 | 0.6 | 1.8 |

As clarified from Table 1A, it has been revealed that the birefringence amount is reduced by applying the pressing force of about 50 N/cm² from the outside to the calcium fluoride crystal material 121. Further, the birefringence amount was measured in the same manner as described above except that the pressing force was changed. As a result, it has been revealed that the birefringence amount is minimum when the pressing force is about 50 N/cm². That is, the intrinsic birefringence is offset by the stress birefringence most efficiently when the pressing force is about 50 N/cm². As described above, when the birefringence based on the stress is applied, then the intrinsic birefringence is offset, and the total birefringence of the material is decreased. Accordingly, the difference in optical path is decreased between the two polarization components of the incoming light beam, the two polarization components being perpendicular to one another and vibrating. Therefore, the Strehl intensity is consequently increased, and it approaches 1. The image formation characteristics are more improved as the Strehl intensity approaches 1. Therefore, it is possible to produce the optical element which is excellent in image formation characteristics by using the material obtained in this embodiment.

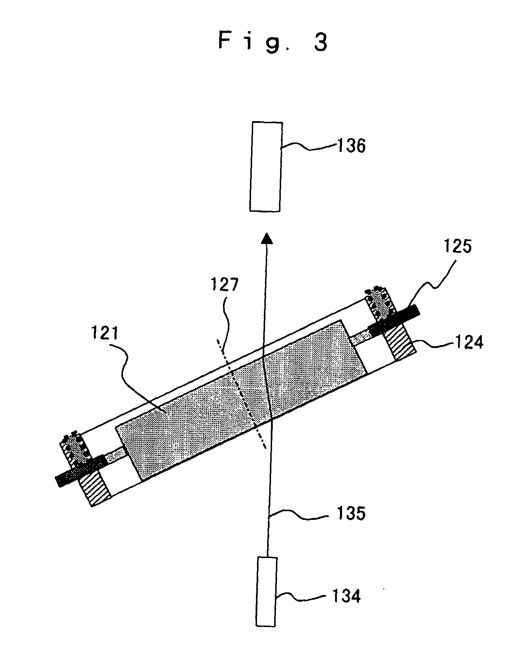

Further, in this embodiment, as shown in Fig. 3, the birefringence with respect to the obliquely incoming light beam was measured as follows. That is, the calcium fluoride crystal material 121 is inclined with respect to a measuring light beam 135 radiated from a light source 134 while holding the calcium fluoride crystal material 121 on the holder 124 by using the internal stress-generating members 125 to detect a transmitted light beam with a detector 136. The angles of inclination of the calcium fluoride crystal material 121 were 30° and 45° with respect to the direction of incidence of the measuring light beam 135. The measurement was performed while moving the light irradiation position at intervals of 15° on a circumference having a diameter of 100 nm in an in-plane area of the calcium fluoride crystal material 121. Results of the measurement are shown in Table 1B.

**Table 1B**

| Angle of inclination [deg] | 193 nm | | 157 nm | |
|---|---|---|---|---|
| | Average [nm/cm] | Maximum [nm/cm] | Average [nm/cm] | Maximum [nm/cm] |
| 30 | 1.1 | 1.3 | 1.5 | 1.6 |
| 45 | 1.3 | 1.5 | 1.8 | 1.9 |

After measuring the birefringence amounts of the calcium fluoride crystal material 121, the calcium fluoride crystal material 121 was once removed from the holder 124 to perform the grinding and the polishing so that a predetermined lens shape was obtained. The relative positional relationship between the orientation of the crystal axis and the holder was recorded before the removal in order to attach the lens after the grinding and the polishing. The grinding was performed such that the projection 111a was formed on the side wall on the outer circumference of the lens as shown in Fig. 1(b). Subsequently, the processed lens was installed to the holder 114 as shown in Figs. 1(a) and 1(b) while maintaining the recorded relative positional relationship. During this process, the lens 111 was held coaxially with the central axis of the holder 114 by using the three holding members 116 provided on the holder 114. Subsequently, the pressing members 115c of the respective internal stress-generating members 115 provided on the holder 114 were pressed against the side wall section 111b formed on the outer circumference of the lens 111. The pressing forces 113 were applied perpendicularly toward the central axis 117 of the lens 111 to generate the compressive stress in the lens 111. The pneumatic pressure was used for the pressing force 113, and the pressure value was 50±5 N/cm². Thus, the optical element 110 for lithography of the first embodiment was manufactured.

The birefringence amounts of the lens 111 in the optical element 110 manufactured by the manufacturing method as described above were measured in accordance with the same method as the method for measuring the birefringence described above. As a result, approximately the same results as those shown in Table 1A were obtained.

### Second Embodiment

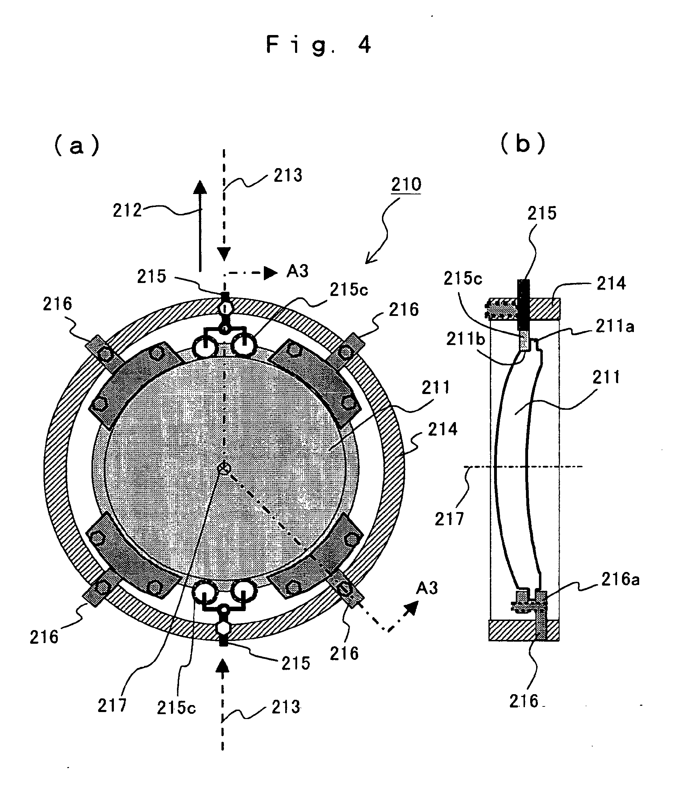

Figs. 4(a) and 4(b) show an optical element for lithography manufactured in a second embodiment. As shown in Figs. 4(a) and 4(b), the optical element 210 manufactured in this embodiment comprises a lens 211, a cylindrical holder 214, four holding members 216, and two internal stress-generating members 215. In this embodiment, the central axis 217 of the lens 211 is the [110] axis of calcium fluoride crystal. As shown in Fig. 4(a), the optical element 210 is constructed in the same manner as in the first embodiment except that the four holding members 216 are provided at intervals of about 90° in the circumferential direction of the holder 214, and the internal stress-generating members 215 are provided at positions of 0° and 180° in the circumferential direction of the holder 214 from the [-110] axis 212 perpendicular to the central axis 217 of the lens respectively. However, as shown in Fig. 4(a), the four holding members 216 and the two internal stress-generating members 215 are provided at such positions that they are not overlapped with each other.

A method for manufacturing the optical element 210 for lithography manufactured in this embodiment will be explained below. At first, the calcium fluoride crystal to be used for the lens 211 was grown by means of the Bridgman method, and any thermal strain was removed by performing a heat treatment step in the same manner as in the first embodiment. Accordingly, the columnar calcium fluoride crystal having a diameter of 250 mm was prepared. Subsequently, a disk-shaped material was cut out from the ingot of the prepared calcium fluoride crystal so that the [110] axis of the crystal was approximately coincident with the central axis 217 of the lens 211. The direction of the [-110] axis 212 perpendicular to the [110] axis was found by means of the X-ray diffraction.

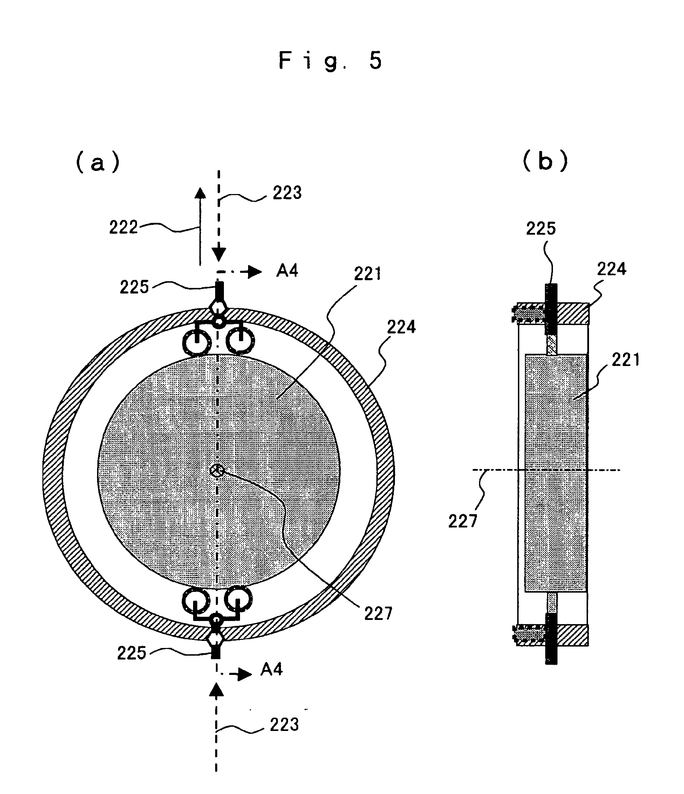

Subsequently, the cut out disk-shaped calcium fluoride crystal material was installed to a holder for measuring the birefringence. Fig. 5 shows this situation. The holder 224 has the same structure as that of the holder 214 shown in Fig. 4 except that the holding members 216 are not provided. When the calcium fluoride crystal material 221 was installed to the holder 224 for measuring the birefringence, the calcium fluoride crystal material 221 was held by the internal stress-generating members 225 while the pressing forces 223 of about 50 N/cm² were applied perpendicularly to the central axis 227 toward the central axis 227 respectively in the two directions by using the internal stress-generating members 225 provided at the positions of 0° and 180° in the circumferential direction of the holder 224 from the [-110] axis 222 of the calcium fluoride crystal material 221.

Light beams having wavelengths of 193 nm and 157 nm were radiated respectively in the direction of the central axis 227 ([110] axis) of the calcium fluoride crystal material 221 held by the internal stress-generating members 225 to measure the birefringence amounts of the calcium fluoride crystal material 221. In this embodiment, a D₂ lamp was used for the light source in the same manner as in the first embodiment, and the birefringence amount was measured by using a birefringence-measuring apparatus. Obtained results are shown in Table 2 below. The measurement was performed while moving the light irradiation position at intervals of 5 mm in the radial direction and at intervals of 30° in the circumferential direction in an in-plane area ranging from the center to the outermost circumference of the calcium fluoride crystal material 221. Table 2 shows maximum values and average values of measured values. For the purpose of comparison, birefringence amounts, which were obtained when no pressing force was applied to the calcium fluoride crystal material 221, are also shown.

**Table 2**

| Pressing force [N/cm²] | 193 nm | | 157 nm | |
|---|---|---|---|---|
| | Average [nm/cm] | Maximum [nm/cm] | Average [nm/cm] | Maximum [nm/cm] |
| 0 | 3.6 | 4.2 | 12.0 | 13.8 |
| 50 | 0.8 | 1.0 | 1.7 | 2.0 |

After measuring the birefringence amounts of the calcium fluoride crystal material 221, the calcium fluoride crystal material 221 was once removed from the holder 224 to perform the grinding and the polishing so that a predetermined lens shape was obtained. The projection 211a was formed on the side wall on the outer circumference of the lens as shown in Fig. 4(b) so that the lens 211 was successfully held by the holding members 216 and the lens 211 was successfully pressed by the pressing members 215c of the internal stress-generating members 215. Subsequently, the processed lens was installed to the holder 214 as shown in Figs. 4(a) and 4(b). During this process, the lens 211 was held coaxially with the central axis of the holder 214 by using the four holding members 216 provided on the holder 214. Subsequently, the pressing members 215c of the respective internal stress-generating members 215 provided on the holder 214 were pressed against the side wall section 211b formed on the outer circumference of the lens 211. The pressing forces 213 were applied perpendicularly to the central axis 217 toward the central axis 217 of the lens 211 to generate the compressive stress in the lens 211. The pneumatic pressure was used for the pressing force 213, and the pressure value was 50±5 N/cm². Thus, the optical element 210 for lithography of the second embodiment was manufactured.

The birefringence amounts of the lens 211 in the optical element 210 manufactured by the manufacturing method as described above were measured in accordance with the same method as the method for measuring the birefringence described above. As a result, approximately the same results as those shown in Table 2 were obtained.

### Third Embodiment

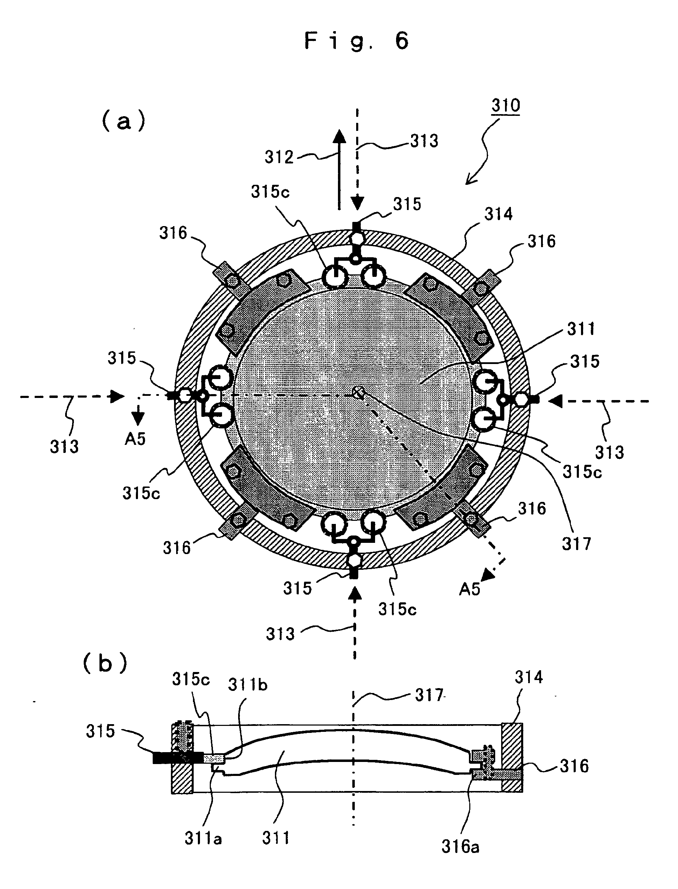

Fig. 6 shows an optical element for lithography manufactured in a third embodiment. As shown in Fig. 6, the optical element 310 manufactured in this embodiment comprises a lens 311, a cylindrical holder 314, four holding members 316, and four internal stress-generating members 315. In this embodiment, the central axis 317 of the lens 311 is the [100] axis of calcium fluoride crystal. As shown in Fig. 6(a), the optical element 310 is constructed in the same manner as in the first embodiment except that the four holding members 316 are provided at intervals of about 90° in the circumferential direction of the holder 314, and the internal stress-generating members 315 are provided at positions of 0°, 90°, 180°, and 270° in the circumferential direction of the holder 314 from the [001] axis 312 perpendicular to the central axis 317 of the lens. However, as shown in Fig. 6(a), the four holding members 316 and the four internal stress-generating members 315 are provided at such positions that they are not overlapped with each other.

A method for manufacturing the optical element 310 for lithography manufactured in this embodiment will be explained below. At first, the calcium fluoride crystal to be used for the lens 311 was grown by means of the Bridgman method, and any thermal strain was removed by performing a heat treatment step in the same manner as in the first embodiment. Accordingly, the columnar calcium fluoride crystal having a diameter of 250 mm was prepared. Subsequently, a disk-shaped material was cut out from the ingot of the prepared calcium fluoride crystal so that the [100] axis of the crystal was approximately coincident with the central axis 317 of the lens 311. The direction of the [001] axis 312 perpendicular to the [100] axis was found by means of the X-ray diffraction.

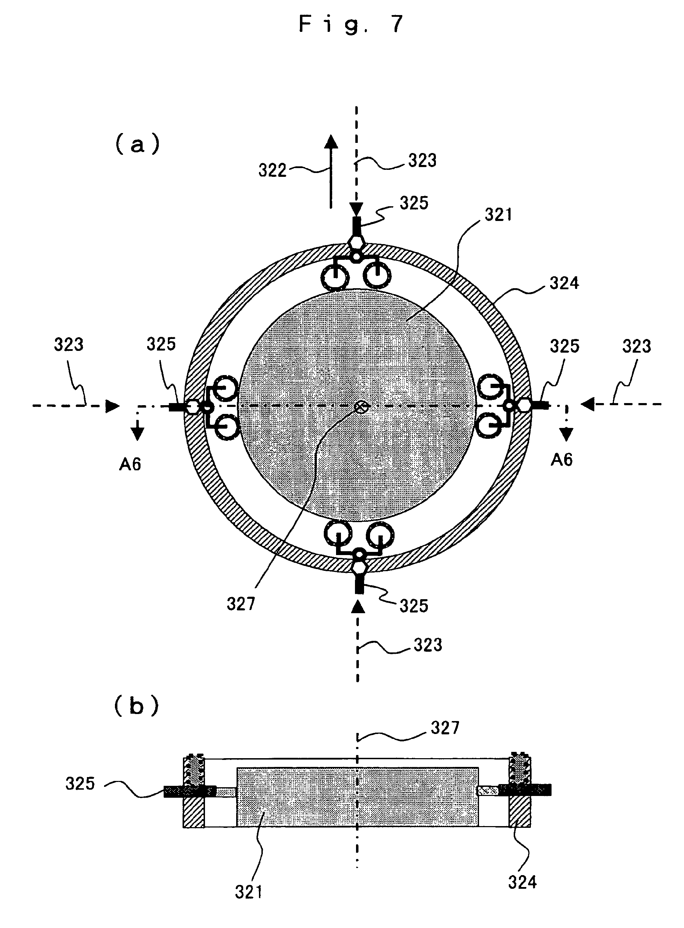

Subsequently, the cut out disk-shaped calcium fluoride crystal material was installed to a holder for measuring the birefringence. Fig. 7 shows this situation. The holder 324 has the same structure as that of the holder 314 shown in Fig. 6 except that the holding members 316 are not provided. When the calcium fluoride crystal material 321 was installed to the holder 324 for measuring the birefringence, the calcium fluoride crystal material 321 was held by the internal stress-generating members 325 by applying the pressing forces 323 of about 50 N/cm² perpendicularly to the central axis 327 toward the central axis 327 respectively in the four directions by using the internal stress-generating members 325 provided at the positions of 0°, 90°, 180°, and 270° in the circumferential direction of the holder 324 from the [001] axis 322 of the calcium fluoride crystal material 321.

Light beams having wavelengths of 193 nm and 157 nm were radiated respectively in the direction of the central axis 327 ([100] axis) of the calcium fluoride crystal material 321 held by the internal stress-generating members 325 to measure the birefringence amounts of the calcium fluoride crystal material 321. In this embodiment, a D₂ lamp was used for the light source in the same manner as in the first embodiment, and the birefringence amount was measured by using a birefringence-measuring apparatus. Obtained results are shown in Table 3 below. The measurement was performed while moving the light irradiation position at intervals of 5 mm in the radial direction and at intervals of 30° in the circumferential direction in an in-plane area ranging from the center to the outermost circumference of the calcium fluoride crystal material 321. Table 3 shows maximum values and average values of measured values. For the purpose of comparison, birefringence amounts, which were obtained when no pressing force was applied to the calcium fluoride crystal material 321, are also shown.

**Table 3**

| Pressing force [N/cm²] | 193 nm | | 157 nm | |
|---|---|---|---|---|
| | Average [nm/cm] | Maximum [nm/cm] | Average [nm/cm] | Maximum [nm/cm] |
| 0 | 0.7 | 1.8 | 1.1 | 2.9 |
| 50 | 0.5 | 0.9 | 0.9 | 1.8 |

After measuring the birefringence amounts of the calcium fluoride crystal material 321, the calcium fluoride crystal material 321 was once removed from the holder 324 to perform the grinding and the polishing so that a predetermined lens shape was obtained. The projection 311a was formed on the side wall on the outer circumference of the lens as shown in Fig. 6(b) so that the lens 311 was successfully held by the holding members 316 and the lens 311 was successfully pressed by the pressing members 315c. Subsequently, the processed lens was installed to the holder 314 as shown in Figs. 6(a) and 6(b). During this process, the lens 311 was held coaxially with the central axis of the holder 314 by using the four holding members 316 provided on the holder 314. Subsequently, the pressing members 315c of the respective internal stress-generating members 315 were pressed against the side wall section 311b formed on the outer circumference of the lens 311. The pressing forces 313 were applied perpendicularly to the central axis 317 toward the central axis 317 of the lens 311 to generate the compressive stress in the lens 311. The pneumatic pressure was used for the pressing force 313, and the pressure value was 50±5 N/cm². Thus, the optical element 310 for lithography of the third embodiment was manufactured.

The birefringence of the lens 311 in the optical element 310 manufactured by the manufacturing method as described above was measured in accordance with the same method as the method for measuring the birefringence described above. As a result, approximately the same results as those shown in Table 3 were obtained.

### Fourth Embodiment

In this embodiment, the internal stress was generated in calcium fluoride crystal by a heat treatment. An explanation will be made below about a method for manufacturing the calcium fluoride crystal for lithography manufactured in this embodiment. At first, the columnar calcium fluoride crystal having a diameter of 300 mm was grown by means of the Bridgman method to obtain three ingots of the calcium fluoride crystal. The ingots of the calcium fluoride crystal were approximately single crystals. Three types of disk-shaped calcium fluoride crystal materials each having a diameter of 230 mm and a thickness of 55 mm were cut out from the ingots so that the {111} plane, the {110} plane, and the {100} plane formed the upper and lower surfaces of lenses respectively.

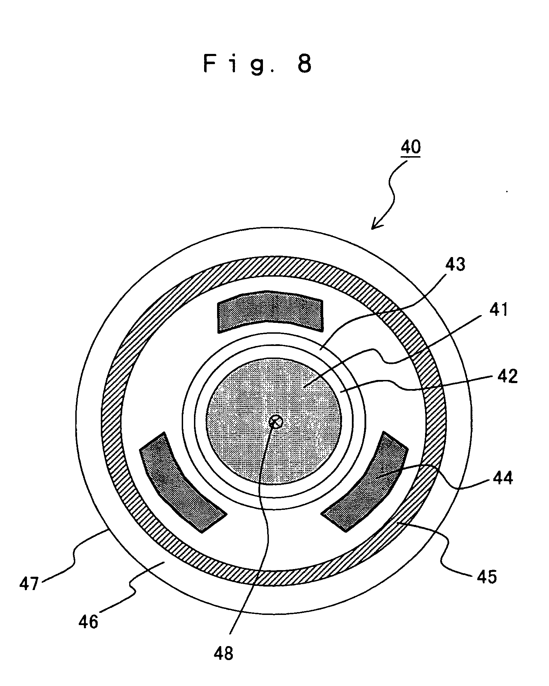

Subsequently, each of the cut out disk-shaped calcium fluoride crystal materials was placed in a heat treatment apparatus shown in Fig. 8 to perform the heat treatment so that the internal stress was generated in the calcium fluoride crystal.

As shown in Fig. 8, a vessel 42 formed of graphite is arranged at a central portion of the cylindrical heat treatment apparatus 40, and an air-tight stainless vessel 43 is provided around the outer circumference thereof. Heat-insulating materials 44 made of alumina and a heater 45 are arranged around the stainless vessel 43 respectively. The heat-insulating materials 44 made of alumina are installed in a divided manner at intervals of 120° in the circumferential direction so that the heat supplied from the heater 45 is successfully distributed in three-fold symmetry in the circumferential direction with respect to the center (48) of the vessel 42. The heater 45 may be an arbitrary heater provided that the temperature in the heat treatment apparatus can be raised up to 1200 °C. In this embodiment, a heater, which was obtained by winding a resistance heating element made of an alloy of nickel and chromium in a coil-shaped form, was used. A heat-insulating material 46 and an outer frame 47 are provided at the outside of the heater 45 respectively. The calcium fluoride crystal material 41, in which the upper and lower surfaces of the cut out disk-shaped material were the {111} plane, was inserted into the vessel 42 of the heat treatment apparatus 40 constructed as described above. In the case of the calcium fluoride crystal material 41 in which the upper and lower surfaces of the disk-shaped material are the {111} plane, the peaks of intrinsic birefringence amount exist at intervals of 120° in the circumferential direction with respect to the central axis. Therefore, when the calcium fluoride crystal material 41, in which the upper and lower surfaces of the disk-shaped material are the {111} plane, is subjected to the heat treatment, it is preferable to form a temperature distribution of three-fold symmetry by using the heat treatment apparatus 40 having the structure as shown in Fig. 8 so that the peaks of intrinsic birefringence amount are reduced.

On the other hand, in the case of the calcium fluoride crystal material in which the upper and lower surfaces of the disk-shaped material were the {110} plane, the heat-insulating materials made of alumina were arranged (not shown) so that a temperature distribution of two-fold symmetry was given in the circumferential direction with respect to the central axis of the calcium fluoride crystal material. Further, in the case of the calcium fluoride crystal material in which the upper and lower surfaces of the disk-shaped material were the {100} plane, the heat-insulating materials made of alumina were arranged (not shown) so that a temperature distribution of four-fold symmetry was given in the circumferential direction with respect to the central axis of the calcium fluoride crystal material.

Subsequently, each of the calcium fluoride crystal materials, in which the upper and lower surfaces of the disk-shaped material were the {111} plane, the {110} plane, or the {100} plane, was inserted into the heat treatment apparatus adapted to each of the birefringence distributions. The interior of the stainless vessel 43 was vacuum-evacuated with an oil-sealed rotary vacuum pump while using an appropriate amount of ammonium hydrogen fluoride. After tightly closing the vessel 43, the heat treatment process of raising the temperature, retaining the temperature, and lowering the temperature was performed. In this embodiment, the following temperature control schedule was adopted for the heat treatment. At first, the temperature was raised at a heating rate of 50 °C/h from 0 °C to 1050 °C, and the temperature was retained at 1050 °C for 50 hours. Subsequently, the temperature was lowered at a cooling rate of 0.5 °C/h from 1050 °C to 700 °C, at a cooling rate of 2.0 °C/h from 700 °C to 500 °C, and at a cooling rate of 5.0 °C/h from 500 °C to 20 °C respectively.

Light beams having wavelengths of 193 nm and 157 nm were radiated onto each of the calcium fluoride crystal materials subjected to the heat treatment as described above, in parallel to the central axis of each of the calcium fluoride crystal materials to measure the birefringence amounts of each of them. In this embodiment, a D₂ lamp was used for the light source in the same manner as in the first embodiment, and the birefringence amount was measured by using a birefringence-measuring apparatus. The measurement was performed at about 280 measuring points in an in-plane area having a diameter within 210 mm of each of the calcium fluoride crystal materials. Obtained results are shown in Table 4. Table 4 shows maximum values and average values of measured values. According to Table 4, it is appreciated that the birefringence amount is sufficiently suppressed with respect to the light beams of the wavelengths of 193 nm and 157 nm in the case of any one of the crystal materials.

**Table 4**

| Crystal plane | 193 nm | | 157 nm | |
|---|---|---|---|---|
| | Average [nm/cm] | Maximum [nm/cm] | Average [nm/cm] | Maximum [nm/cm] |
| {111} | 0.2 | 0.6 | 0.5 | 1.1 |
| {110} | 0.7 | 1.0 | 1.1 | 1.8 |
| {100} | 0.5 | 0.8 | 0.9 | 1.5 |

### Fifth Embodiment

In this embodiment, the internal stress was generated in calcium fluoride crystal by means of a heat treatment and an external pressing treatment. An explanation will be made below about a method for manufacturing the calcium fluoride crystal for lithography manufactured in this embodiment. At first, the columnar calcium fluoride crystal having a diameter of 300 mm was grown by means of the Bridgman method to obtain three ingots of the calcium fluoride crystal. The ingots of the calcium fluoride crystal were approximately single crystals. Three types of disk-shaped calcium fluoride crystal materials each having a diameter of 230 mm and a thickness of 55 mm were cut out from the ingots so that the {111} plane, the {110} plane, and the {100} plane formed the upper and lower surfaces of lenses respectively.

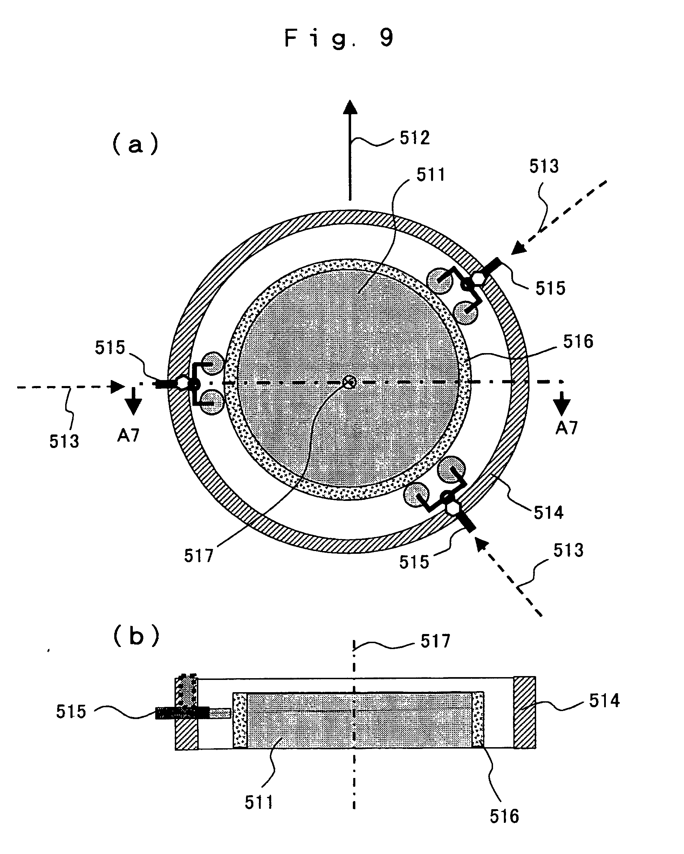

Subsequently, as shown in Fig. 9, a blanket 516 made of graphite was wound around the disk-shaped material 511 of the calcium fluoride crystal cut out from each of the ingots, and then the material 511 was arranged in a cylindrical holder 514. The pressing forces were applied perpendicularly to the central axis toward the central axis of the calcium fluoride crystal material 511 from the outside by using the internal stress-generating members 515 provided on the holder 514 to generate the internal stress in the calcium fluoride crystal.

In the case of the calcium fluoride crystal material in which the upper and lower surfaces of the disk-shaped material were the {111} plane, the calcium fluoride crystal material 511 was pressed toward the central axis 517 from the outside in the radial direction of the calcium fluoride crystal material 511 by using the internal stress-generating members 515 provided at positions of 30°, 150°, and 270° in the circumferential direction of the holder 514 from the [-110] axis 512 in the direction perpendicular to the central axis 517 of the calcium fluoride crystal material 511 to generate the compressive stress of three-fold symmetry in the calcium fluoride crystal material 511. The pressing force was about 50 N/cm².

The calcium fluoride crystal material 511 in the state in which- t-he- compressive stress -was generated by the respective internal stress-generating members 515 was introduced into the heat treatment apparatus together with the holder 514 to perform the heat treatment so that the heat was applied uniformly in the circumferential direction with respect to the central axis 517 of the calcium fluoride crystal material 511. The following temperature control schedule was adopted for the heat treatment in the same manner as in the fourth embodiment. At first, the temperature was raised at a heating rate of 50 °C/h from 0 °C to 1050 °C, and the temperature was retained at 1050 °C for 50 hours. Subsequently, the temperature was lowered at a cooling rate of 0.5 °C/h from 1050 °C to 700 °C, at a cooling rate of 2.0 °C/h from 700 °C to 500 °C, and at a cooling rate of 5.0 °C/h from 500 °C to 20 °C respectively.

In the case of the calcium fluoride crystal material in which the upper and lower surfaces of the disk-shaped material were the {110} plane, the calcium fluoride crystal material was installed to a holder in which the pressing forces were applied in two-fold symmetry in the circumferential direction with respect to the central axis of the calcium fluoride crystal material, i.e., a holder in which the internal stress-generating members were provided opposingly in the radial direction to generate the internal stress in the calcium fluoride crystal material. The heat treatment was performed in this state. The temperature control schedule was designed in the same manner as for the disk-shaped material in which the upper and lower surfaces were the {111} plane. In the case of the calcium fluoride crystal material in which the upper and lower surfaces of the disk-shaped material were the {100} plane, the calcium fluoride crystal material was installed to a holder in which the pressing forces were applied in four-fold symmetry in the circumferential direction with respect to the central axis of the calcium fluoride crystal material, i.e., a holder in which the internal stress-generating members were provided at intervals of angles of rotation of 90° to generate the internal stress in the calcium fluoride crystal material. The heat treatment was performed in this state. The temperature control schedule was designed in the same manner as for the disk-shaped material in which the upper and lower surfaces were the {111} plane.

After the heat treatment, each of the calcium fluoride crystal materials was removed from the holder, and the outer circumference of each of the calcium fluoride crystal materials was ground to have a thickness of about 2 mm. Light beams having wavelengths of 193 nm and 157 nm were radiated in the direction of the central axis of each of the calcium fluoride crystal materials after the grinding to measure the birefringence amounts of each of the calcium fluoride crystal materials. In this embodiment, a D₂ lamp was used for the light source in the same manner as in the first embodiment, and the birefringence amount was measured by using a birefringence-measuring apparatus. The measurement was performed at about 280 points in total while moving the measuring point at intervals of 5 mm in the radial direction and at intervals of 30° in the circumferential direction in an in-plane area having a diameter of 210 mm from the center of each of the calcium fluoride crystal materials. Obtained results are shown in Table 5. Table 5 shows maximum values and average values of measured values. According to Table 5, it is appreciated that the birefringence amount is sufficiently suppressed in any one of the crystal materials.

**Table 5**

| Plane | 193 nm | | 157 nm | |
|---|---|---|---|---|
| | Average [nm/cm] | Maximum [nm/cm] | Average [nm/cm] | Maximum [nm/cm] |
| {111} | 0.3 | 0.8 | 0.6 | 1.3 |
| {110} | 0.7 | 1.2 | 1.3 | 1.9 |
| {100} | 0.4 | 0.9 | 1.0 | 1.6 |

The first to third embodiments described above are illustrative of the case in which the holding member for holding the lens in the optical element is distinct from the internal stress-generating member for generating the internal stress in the lens. However, the present invention is not limited thereto. The holding member may have an internal stress-generating function to-hold and press the lens with only the holding member. In this case, for example, it is possible to provide, on the holder, a screw which makes the arm of the holding member to be movable penetratingly through the wall surface of the holder and which fixes the arm after the pressing. Alternatively, the holder may be omitted from the holder as well by supporting the lens with the internal stress-generating member.

The first to fifth embodiments described above are illustrative of the use of the calcium fluoride crystal as the material for forming the lens. However, the present invention is not limited thereto. For example, it is also possible to use any other fluoride crystal belonging to the tesseral system, including, for example, barium fluoride and strontium fluoride, in which it is possible to reduce the birefringence in the same manner as in the embodiments described above.

The first to fifth embodiments described above are illustrative of the case in which the fluoride crystal material is cut out so that the {111} plane, the {110} plane, and the {100} plane of the fluoride crystal are the upper and lower surfaces of the disk when the fluoride crystal material is cut out in the disk-shaped configuration from the ingot. However, the fluoride crystal material may be cut out in a plane other than the planes described above. In such a case, when the internal stress is generated in the fluoride crystal material by the heat treatment or the pressing treatment, the pressure distribution in the pressing treatment and/or the temperature distribution in the heat treatment in the circumferential direction with respect to the central axis of the fluoride crystal material may be appropriately changed in conformity with the characteristics of the birefringence of the cut out crystal plane.

### Sixth Embodiment

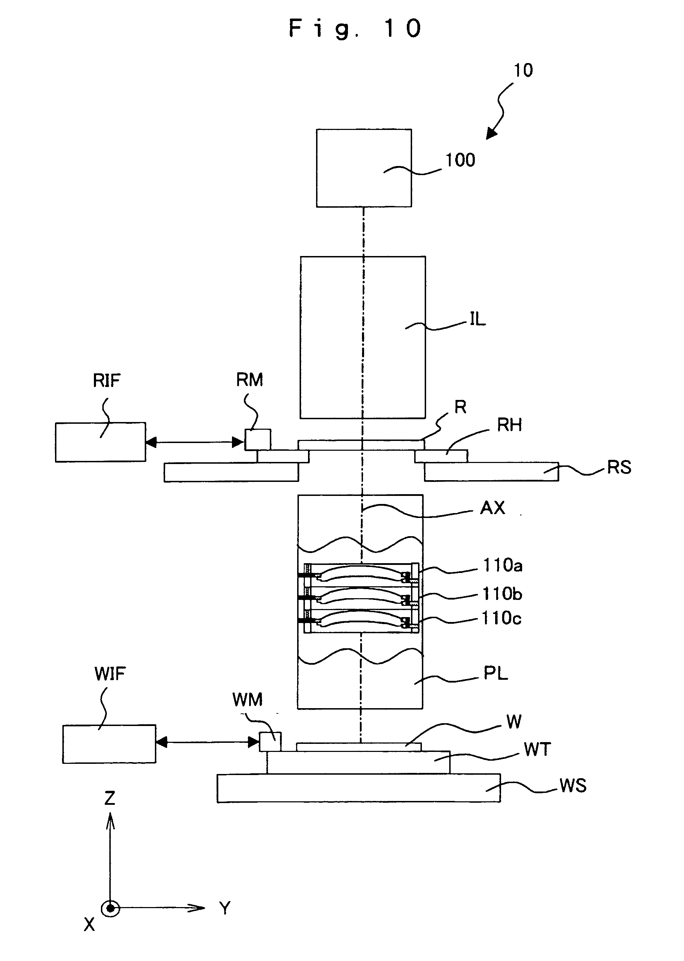

Fig. 10 shows an exposure apparatus provided with a projection optical system which accommodates lenses made of the fluoride crystal manufactured in the first embodiment, as an example of the photolithography apparatus. Fig. 10 conceptually shows the exposure apparatus 10 for photolithography which uses an F₂ laser as the light source. In Fig. 10, reference numeral 100 indicates the F₂ laser light source (oscillation central wavelength: 157.6 nm), IL indicates an illumination optical system, PL indicates a projection optical system, R indicates a reticle, and W indicates a silicon wafer to be subjected to the reduction projection. The light beam, which is radiated from the light source 100, passes through the illumination optical system IL, and it illuminates the reticle R having a predetermined pattern formed thereon at a uniform illuminance.

The optical path between the light source 100 and the illumination optical system IL is tightly closed by a casing (not shown). The space, which ranges from the light source 100 to the lens of the illumination optical system IL disposed closest to the reticle, is filled with an inert gas which has a low absorption coefficient with respect to the exposure light beam. The reticle R is retained by the aid of a reticle holder RH so that the reticle R is parallel to the XY plane on a reticle stage RS. A pattern, which is to be transferred onto the wafer W, is formed on the reticle R. A rectangular (slit-shaped) area of the entire pattern area, which has a short side in the X direction and which has a long side in the Y direction, is illuminated.

The reticle stage RS is movable two-dimensionally along the reticle plane (i.e., the XY plane). The position coordinate of the reticle stage RS is measured by a reticle interferometer RIF based on the use of a reticle movement mirror RM, and the position is controlled thereby. The light beam, which has passed through the pattern formed on the reticle R, forms a reticle pattern image on the wafer W as the photosensitive substrate via the projection optical system PL. The wafer W is retained by the aid of a wafer table WT so that the wafer W is parallel to the XY plane on a wafer stage WS. The wafer stage WS is movable two-dimensionally along the XY plane so that a rectangular exposure area, which has a short side in the X direction and which has a long side in the Y direction on the wafer W, optically corresponds to the rectangular illumination area on the reticle R. The position coordinate of the wafer table WT is measured by a wafer interferometer WIF by using a wafer movement mirror WM, and the position is controlled thereby.

The projection optical system PL is constructed so that the interior is retained in an air-tight state. The internal space of the projection optical system PL is filled with the inert gas. As shown in Fig. 10, the holder-equipped optical elements 110a, 110b, 110c manufactured in the first embodiment are installed in the projection optical system PL by installing the respective holders to a body tube of the projection optical system PL. The reticle R, the reticle stage RS, and other components are arranged in the narrow optical path between the illumination optical system IL and the projection optical system PL. The inert gas is charged to the inside of the casing (not shown) which surrounds the reticle R, the reticle stage RS, and other components in a tightly sealed manner.

An atmosphere, in which the exposure light beam is scarcely absorbed, is formed over the entire optical path ranging from the light source 100 to the wafer W as described above. As described above, the illumination area on the reticle R and the exposure area on the wafer W illuminated via the projection optical system PL have the rectangular shapes with the short sides extending in the X direction. Therefore, when the reticle stage RS and the wafer stage WS are synchronously moved (subjected to the scanning) in the short side direction of each of the rectangular illumination area and the exposure area, i.e., in the X direction while controlling the positions of the reticle R and the wafer W by using, for example, the driving system and the interferometers (RIF, WIF), the reticle pattern is subjected to the scanning exposure onto the area which has the width equal to the long side of the exposure area and which has the length corresponding to the amount of movement (scanning) of the wafer W on the wafer W.

When the exposure apparatus constructed as described above is used, it is possible to realize the photolithography in which a fine and vivid pattern is obtained. As described above, the holder-equipped optical elements 110a, 110b, 110c manufactured in the first embodiment can be installed to the body tube of the projection optical system PL as they are as shown in Fig. 10. Therefore, the projection optical system can be assembled while maintaining the satisfactory image formation characteristics of the lenses. In this arrangement, the image formation characteristics of the projection optical system can be also controlled by adjusting the stress-generating members provided on the holders. This arrangement is advantageous in view of the maintenance as well. The lenses made of the fluoride crystal manufactured in the embodiments described above can be used not only for the lenses for the projection optical system but also for the various lenses used for the illumination optical system. Details of the structure of the exposure apparatus are described, for example, in United States Patent Nos. 6,400,441 B1 and 6,391,503 B2. The contents of these United States Patents are incorporated herein by reference in the case of permission of the domestic laws and ordinances or rules of the designated state or the selected state of the international patent application.

### INDUSTRIAL APPLICABILITY

As described above, according to the fluoride crystal material, the optical device (optical element), and the method for producing the same, it is possible to minimize the influence exerted on the optical performance by the intrinsic birefringence of the fluoride crystal. Therefore, when the fluoride crystal material is used, for example, as a material for the projection lens to be used for the projection exposure apparatus, especially for the projection exposure apparatus which uses the light source of the ArF laser or the F₂ laser, then it is possible to improve the Strehl value, and the high resolution exposure is realized. Further, in the optical device of the present invention, the image formation characteristics of the lens are adjusted by the holder. Therefore, it is easy to perform the operation for incorporating the lens, the adjustment of the optical characteristics, and the maintenance.

## Claims

1. A fluoride crystal material for an optical element to be used for a photolithography apparatus, wherein a birefringence amount with respect to a light source having a wavelength of about 157 nm has a maximum value of not more than 2.0 nm/cm.

2. A fluoride crystal material for an optical element to be used for a photolithography apparatus, wherein a birefringence amount with respect to a light source having a wavelength of about 193 nm has a maximum value of not more than 1.0 nm/cm.

3. The fluoride crystal material according to claim 1 or 2, wherein the fluoride crystal material is a calcium fluoride crystal, and a light-incoming plane of the calcium fluoride crystal is a {111} plane, a {110} plane, or a {100} plane.

4. The fluoride crystal material according to claim 3, wherein an internal stress is generated in the fluoride crystal material so that an intrinsic birefringence amount of the fluoride crystal material is reduced.

5. The fluoride crystal material according to claim 4, wherein the internal stress is generated by externally pressing the fluoride crystal material.

6. The fluoride crystal material according to claim 4, wherein the internal stress is generated by heat-treating the fluoride crystal material.

7. The fluoride crystal material according to claim 4, wherein the internal stress is generated by a heat treatment and an external pressing treatment applied to the fluoride crystal material.

8. An optical element which is formed of the fluoride crystal material as defined in claim 1 or 2.

9. A photolithography apparatus comprising the optical element as defined in claim 8.

10. An optical device to be used for a photolithography apparatus, the optical device comprising:
a lens which is formed of a fluoride crystal material;
a holder which holds the lens; and
a pressing member which is attached to the holder and which presses the lens to generate a stress in the lens.

11. The optical device according to claim 10, wherein the pressing member includes a plurality of pressing sections, and the respective pressing sections press the lens at different positions on an outer circumference of the lens.

12. The optical device according to claim 11, wherein the respective pressing sections press the lens at rotationally symmetric positions on the outer circumference of the lens.

13. The optical device according to claim 12, wherein the rotationally symmetric position is any one of positions of two-fold symmetry, three-fold symmetry, and four-fold symmetry.

14. The optical device according to claim 11, further comprising a fixing member which fixes the pressing sections on the holder in a state in which the respective pressing sections press the lens.

15. The optical device according to claim 10, wherein a pressing force is applied to the pressing member so that an intrinsic birefringence amount of the fluoride crystal material is reduced.

16. The optical device according to claim 10, wherein the holder is a part of a body tube of a projection optical system to be used for photolithography.

17. The optical device according to claim 10, wherein the fluoride crystal material is a calcium fluoride crystal, and a maximum value of a birefringence amount with respect to a light beam having a wavelength of about 157 nm is not more than 2.0 nm/cm within an effective aperture of the lens.

18. The optical device according to claim 10, wherein the fluoride crystal material is a calcium fluoride crystal, and a maximum value of a birefringence amount with respect to a light beam having a wavelength of about 193 nm is not more than 1.0 nm/cm within an effective aperture of the lens.

19. A projection optical system comprising the optical device as defined in claim 16.

20. A photolithography apparatus comprising the projection optical system as defined in claim 19.

21. A method for producing a fluoride crystal material for an optical element to be used for a photolithography apparatus, the method comprising a step of growing a fluoride crystal and a heat treatment step of heating the grown fluoride crystal to a raised temperature and retaining the temperature for a certain period of time followed by cooling the grown fluoride crystal, wherein:
the fluoride crystal is heated in the heat treatment step so that a nonuniform heat distribution is generated in the fluoride crystal.

22. The method for producing the fluoride crystal material according to claim 21, wherein the nonuniform heat distribution is such a heat distribution that an internal stress is generated to counteract an intrinsic birefringence amount of the fluoride crystal.

23. The method for producing the fluoride crystal material according to claim 21 or 22, wherein the fluoride crystal is a calcium fluoride crystal.

24. A method for producing a fluoride crystal material for an optical element to be used for a photolithography apparatus, the method comprising a step of growing a fluoride crystal and a heat treatment step of heating the grown fluoride crystal to a raised temperature and retaining the temperature for a certain period of time followed by cooling the grown fluoride crystal, wherein:
the method further comprises a step of partially pressing the fluoride crystal so that an internal stress is generated in the fluoride crystal to which the heat treatment step is applied.

25. The method for producing the fluoride crystal material according to claim 24, wherein a pressing force is partially applied to the fluoride crystal by using a holder to hold the fluoride crystal, and the holder, which holds the fluoride crystal, is subjected to the heat treatment step.

26. The method for producing the fluoride crystal material according to claim 24 or 25, wherein the fluoride crystal is a calcium fluoride crystal.
